# EUROPÄISCHE PATENTSCHRIFT

(11) **EP 1 866 247 B1**
(45) Veröffentlichungstag und Bekanntmachung des Hinweises auf die Patenterteilung: **26.08.2009**
(21) Anmeldenummer: 06723370.0
(22) Anmeldetag: 11.03.2006
(51) Int. Cl.: C01B 33/02, C01B 33/037, C30B 11/00, C30B 29/06, H01L 31/18, B01J 19/00, B01J 19/24

(54) **VORRICHTUNG UND VERFAHREN ZUM KRISTALLISIEREN VON NICHTEISENMETALLEN**
DEVICE AND METHOD FOR THE CRYSTALLISATION OF NONFERROUS METALS
DISPOSITIF ET PROCEDE DE CRISTALLISATION DE METAUX NON FERREUX

(30) Priorität: 23.03.2005 DE 102005013410
(43) Veröffentlichungstag der Anmeldung: 19.12.2007
(73) Patentinhaber: Deutsche Solar AG, 09599 Freiberg (DE)
(72) Erfinder: MÜLLER, Armin, 09599 Freiberg (DE); GHOSH, Michael, 52074 Aachen (DE); SEIDEL, Jens, 09599 Freiberg (DE); GEYER, Bert, 50070 Aachen (DE)
(74) Vertreter: Rau, Albrecht
(86) Internationale Anmeldenummer: PCT/EP2006/002258
(87) Internationale Veröffentlichungsnummer: WO 2006/099955

(56) Entgegenhaltungen:
- EP-A- 0 748 884
- DE-A1- 10 234 250
- JP-A- 2000 001 308

## Beschreibung

Die Erfindung betrifft eine Vorrichtung zum Schmelzen und/oder Kristallisieren von Nichteisenmetallen, insbesondere von Silizium. Ferner betrifft die Erfindung ein Verfahren zum Schmelzen und/oder Kristallisieren von Nichteisenmetallen, insbesondere von Silizium. Des weiteren betrifft die Erfindung die Verwendung des nach dem erfindungsgemäßen Verfahren kristallisierten Nichteisenmetalls, insbesondere des Siliziums, in der Photovoltaik.

Es ist seit langem bekannt, Silizium in Quarzkokillen einzuschmelzen und kristallisieren zu lassen, um multikristalline Siliziumblöcke für die Weiterverarbeitung in der Photovoltaik herzustellen. Während des Kristallisierens und Abkühlens des Siliziums erfolgt die Wärmeabfuhr durch Abstrahlung von Wärme an den Außenwänden der Kokille und der Oberfläche des Siliziums. Nachteilig bei diesem Verfahren ist, dass das Silizium häufig ungleichmäßig abkühlt, so dass starke thermische Spannungen entstehen, die eine Versetzungsbildung und Versetzungsmultiplikation begünstigen und Risse im erstarrten, blockförmigen Silizium verursachen. Außerdem begünstigt die ungleichmäßige Abkühlung eine Rückdiffusion von Fremdstoffen, insbesondere Metallen, aus Randbereichen in das Innere des blockförmigen Siliziums. Sowohl die Versetzungen als auch die rückdiffundierten Fremdstoffe wirken als Rekombinationszentren und reduzieren den photovoltaischen Wirkungsgrad von Solarzellen.

Aus der JP 2000 001308 A ist eine Vorrichtung und ein Verfahren zur Herstellung von Silizium bekannt, wobei oberhalb eines Behälters ein Kühl-Element angeordnet ist, dass zum Kristallisieren des flüssigen Siliziums mit diesem in Kontakt gebracht wird.

Der Erfindung liegt die Aufgabe zugrunde, eine Vorrichtung und ein Verfahren zum Schmelzen und/oder Kristallisieren von Nichteisenmetallen, insbesondere von Silizium, derart weiterzubilden, dass die Güte des erstarrten Nichteisenmetalls und der daraus resultierende photovoltaische Wirkungsgrad von aus dem Nichteisenmetall hergestellten Solarzellen erhöht wird.

Diese Aufgabe wird durch die Merkmale der unabhängigen Ansprüche 1 und 7 gelöst. Der Kern der Erfindung besteht darin, dass das Kristallisieren des Nichteisenmetalls gesteuert wird. Steuern im Sinne dieser Erfindung bedeutet Steuern im engeren Sinne ohne eine Rückkopplung einer das Kristallisieren kennzeichnenden Messgröße, aber auch Regeln mit einer Rückkopplung einer das Kristallisieren kennzeichnenden Messgröße. Zur Steuerung des Kristallisiervorgangs ist mindestens ein steuerbares Kühl-Element vorgesehen, das zur aktiven Abfuhr von Wärme aus dem Nichteisenmetall dient. Durch das gesteuerte Kristallisieren des flüssigen Nichteisenmetalls werden thermische Spannungen vermindert, was zu einer Reduzierung von Versetzungen und von in das Innere des blockförmigen Nichteisenmetalls zurückdiffundierten Fremdstoffen führt. Dadurch werden weniger Rekombinationszentren erzeugt, so dass die Güte des erstarrten Nichteisenmetalls und der photovoltaische Wirkungsgrad von aus dem Nichteisenmetall hergestellten Solarzellen verbessert wird. Gleichzeitig ist eine Verringerung der Zykluszeit beim Kristallisieren des flüssigen Nichteisenmetalls und bei der anschließenden Abkühlung des erstarrten, blockförmigen Nichteisenmetalls möglich.

Weitere vorteilhafte Ausgestaltungen ergeben sich aus den Unteransprüchen.

Zusätzliche Merkmale und Einzelheiten der Erfindung ergeben sich aus der Beschreibung eines Ausführungsbeispiels anhand der Zeichnung.

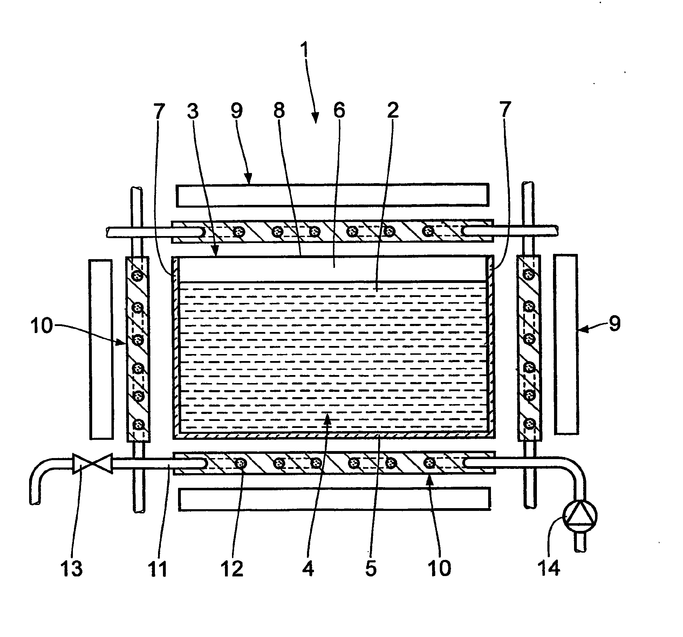

- Fig. 1: zeigt eine schematische Darstellung einer Vorrichtung zum Schmelzen und/oder Kristallisieren von Nichteisenmetallen.

Eine als Ganzes mit 1 bezeichnete Vorrichtung zum Schmelzen und/oder Kristallisieren eines Nichteisenmetalls 2, insbesondere von Silizium, weist eine als Behälter 3 ausgebildete Kokille auf, die im Wesentlichen in Form eines nach oben offenen Quaders ausgebildet ist und einen im Wesentlichen quaderförmigen Innenraum 4 nach fünf Seiten begrenzt. Die Kokille 3 ist einstückig aus Quarz ausgebildet und weist einen Kokillen-Boden 5 und zwei einander gegenüberliegende Kokillen-Seitenwände 6 sowie zwei einander gegenüberliegende Kokillen-Stirnwände 7 auf. Gegenüberliegend zu dem Kokillen-Boden 5 ist zum Befüllen der Kokille 3 eine Kokillen-Öffnung 8 vorgesehen. Der Innenraum 4 der Kokille 3 ist annähernd bis zu der Kokillen-Öffnung 8 mit Silizium 2 befüllt.

Die jeweiligen Außenwände des Kokillen-Bodens 5, der Kokillen-Seitenwände 6, der Kokillen-Stirnwände 7 und der Kokillen-Öffnung 8 werden nachfolgend auch als Seitenflächen bezeichnet, wobei diese im Wesentlichen parallel zu korrespondierenden Außenflächen des Siliziums 2 innerhalb des Innenraums 4 sind.

Parallel zu den Seitenflächen ist beabstandet von diesen jeweils ein elektrisch beheizbares Heiz-Element 9 angeordnet, das zur aktiven und gezielten Zufuhr von Wärme in das Silizium 2 steuerbar ist. Alternativ können mindestens ein, insbesondere mindestens zwei, insbesondere mindestens vier Heiz-Elemente 9 beabstandet zu einer korrespondierenden Anzahl von Seitenflächen angeordnet sein. Jedes Heiz-Element 9 erstreckt sich im Wesentlichen über die gesamte zugehörige Seitenfläche. Die Heiz-Elemente 9 sind mit Ausnahme des der Kokillen-Öffnung 8 gegenüberliegenden HeizElements 9 relativ zu der Kokille 3 festgelegt. Alternativ kann vorgesehen sein, dass jedes Heiz-Element 9 entweder manuell oder automatisch mittels eines nicht dargestellten Antriebes entlang den Seitenflächen bewegbar ist, sodass in einem deaktivierten Zustand die Heiz-Elemente 9 den zugehörigen Seitenflächen nicht gegenüberliegen.

Zwischen jedem Heiz-Element 9 und der zugehörigen Seitenfläche ist zur aktiven Abfuhr von Wärme aus dem Silizium 2 ein steuerbares Kühl-Element 10 angeordnet. Jedes Kühl-Element 10 ist im Wesentlichen parallel und beabstandet zu der zugehörigen Seitenfläche angeordnet, wobei sich das Kühl-Element 10 über die gesamte Seitenfläche erstreckt. Die Kühl-Elemente 10 sind mit Ausnahme des der Kokillen-Öffnung 8 gegenüberliegenden Kühl-Elements 10 relativ zu der Kokille 3 festgelegt. Alternativ kann vorgesehen sein, dass jedes Kühl-Element 10 entweder manuell oder automatisch mittels eines nichtdargestellten Antriebes entlang den Seitenflächen bewegbar ist, sodass in einem deaktivierten Zustand die Kühl-Elemente 10 den zugehörigen Seitenflächen nicht gegenüberliegen.

Alternativ zu der Anordnung der Kühl-Elemente 10 zwischen den HeizElementen 9 und den zugehörigen Seitenflächen kann vorgesehen sein, dass gegenüber einer Seitenfläche entweder ein Heiz-Element 9 oder ein Kühl-Element 10 angeordnet ist. Beispielsweise können zwei Heiz-Elemente 9 gegenüberliegend zu den Kokillen-Seitenwänden 6 und zwei Kühl-Elemente 10 gegenüberliegend zu dem Kokillen-Boden 5 und der Kokillen-Öffnung 8 angeordnet sein.

Jedes Kühl-Element 10 weist ein mäanderförmig ausgebildetes Kühl-Rohr 11 auf, das zur Abfuhr von Wärme von einem Kühl-Fluid, insbesondere einem Kühl-Gas 12, durchströmt wird. Die Kühl-Rohre 11 bestehen entweder aus einem hochtemperaturbeständigen, nicht metallischen Material, insbesondere aus Graphit, oder aus einem hochtemperaturbeständigen, metallischen Material. Ein hochtemperaturbeständiges Material im Sinne dieser Erfindung weist eine Schmelztemperatur von mehr als 1600° C, insbesondere von mehr als 2000° C und insbesondere von mehr als 2400° C auf.

Jedes Kühl-Element 10 weist weiterhin ein Durchflusssteuer-Element 13 in Form eines steuerbaren Ventils zur Steuerung der Durchflussmenge des Kühl-Gases 12 auf. Weiterhin ist zur Steuerung des Druckes des Kühl-Gases 12 ein Drucksteuer-Element 14 in Form einer steuerbaren Pumpe vorgesehen. Jedes Kühl-Element 10 ist mit dem Kühl-Rohr 11 an einen nicht dargestellten Wärmetauscher angeschlossen und bildet einen geschlossenen Kreislauf für das Kühl-Gas 12 aus, wobei in dem Wärmetauscher die von den Kühl-Gas 12 aufgenommene Wärme abgeführt wird. Alternativ können die Kühl-Elemente 10 auch einen offenen Kreislauf für das Kühl-Gas 12 ausbilden, sodass das Kühl-Gas 12 ständig ersetzt wird.

Im Folgenden wird die Funktionsweise der erfindungsgemäßen Vorrichtung 1 beschrieben. Zunächst wird die Kokille 3 mit pulver- oder granulatförmigem Silizium 2 befüllt. Hierzu sind das der Kokillen-Öffnung 8 gegenüberliegende Heiz-Element 9 und Kühl-Element 10 derart positioniert, dass die Kokillen-Öffnung 8 zum Befüllen frei zugänglich ist. Nach dem Befüllen wird das der Kokillen-Öffnung 8 gegenüberliegende Heiz-Element 9 und Kühl-Element 10 zum Beheizen und Kühlen des Siliziums 2 parallel und gegenüberliegend zu der Kokillen-Öffnung 8 angeordnet. Die Heiz-Elemente 9 werden nun derart elektrisch beheizt, dass dem Silizium 2 aktiv Wärme zugeführt wird und dieses vollständig aufschmilzt. Die Wärme strömt dabei zwischen den mäanderförmigen Kühl-Rohren 11 der Kühl-Elemente 10 hindurch. Alternativ dazu kann auch bereits aufgeschmolzenes und flüssiges Silizium 2 in die Kokille 3 eingefüllt werden.

Nach dem Aufschmelzen des Siliziums 2 liegt dieses flüssig innerhalb der Kokille 3 vor. Es folgt das gerichtete und gesteuerte Kristallisieren und Erstarren des Siliziums 2. Gerichtet im Sinne dieser Erfindung bedeutet von unten nach oben, also entgegen die Schwerkraft. Zum gesteuerten Kristallisieren des flüssigen Siliziums 2 wird mittels der steuerbaren Kühl-Elemente 10 aktiv Wärme aus dem flüssigen Silizium 2 abgeführt. Das durch die Kühl-Rohre 11 strömende Kühl-Gas 12 nimmt die abgestrahlte Wärme des Siliziums 2 auf und transportiert diese ab. Als Kühl-Gas 12 sind prinzipiell beliebige Gase oder Gasgemische einsetzbar, wie beispielsweise Argon.

Zur Steuerung der Abfuhr von Wärme wird die Durchflussmenge des Kühl-Gases 12 mittels des Ventils 13 und/oder der Druck des Kühl-Gases 12 mittels der Pumpe 14 gesteuert. Die Kühl-Elemente 10 werden mit einem Druck des Kühl-Gases 12 von 10 mbar bis 10 bar, insbesondere von 500 mbar bis 8 bar, und insbesondere von 1 bar bis 5 bar betrieben. Weiterhin werden die Kühl-Elemente 10 mit einer Durchflussmenge des Kühl-Gases 12 von 1 m³/h bis 10000 m³/h, insbesondere von 50 m³/h bis 5000 m³/h, und insbesondere von 100 m³/h bis 1000 m³/h betrieben.

Die Kühl-Elemente 10 werden beim Kristallisieren derart angesteuert, dass dieses gerichtet erfolgt. Insbesondere wird das dem Kokillen-Boden 5 gegenüberliegende Kühl-Element 10 derart angesteuert, dass es eine im Vergleich zu den anderen Kühl-Elementen 10 verstärkte Kühl-Wirkung aufweist. Durch das gesteuerte Kristallisieren des flüssigen Siliziums 2 werden thermische Spannungen aufgrund eines zu schnellen oder ungleichmäßigen Abkühlens verhindert. Dadurch werden Versetzungen und Risse im erstarrten Silizium 2 reduziert. Die gesteuerte Abfuhr von Wärme an der der Kokillen-Öffnung 8 gegenüberliegenden und frei liegenden Außenfläche des Siliziums 2 führt zusätzlich dazu, dass die Rückdiffusion von Fremdstoffen, insbesondere von metallischen Fremdstoffen, aus einem Randbereich des blockförmigen Siliziums 2 in das Innere während der Abkühlung reduziert wird. Die geringere Anzahl an Versetzungen und Fremdstoffen reduziert die möglichen Rekombinationszentren und erhöht den photovoltaischen Wirkungsgrad von aus dem blockförmigen Silizium 2 hergestellten Solarzellen. Außerdem wird durch die aktive und steuerbare Abfuhr von Wärme aus dem Silizium 2 die Zykluszeit bei der Herstellung von blockförmigen, festen Silizium 2, insbesondere in der Abkühlphase des bereits erstarrten Siliziums 2, reduziert. Außerdem wird durch die flexibel und schnell steuerbare Abkühlung des Siliziums 2 eine gezielte Einstellung und Anpassung der Güte des erstarrten Siliziums 2 in Abhängigkeit der Abkühlraten möglich.

Alternativ zu dem oben beschriebenen Ausführungsbeispiel kann das Aufschmelzen und das Kristallisieren des Siliziums 2 auch in separaten Vorrichtungen stattfinden.

## Patentansprüche

1. Vorrichtung zum Schmelzen und/oder Kristallisieren von Nichteisenmetallen (2), insbesondere von Silizium, umfassend
a. einen Behälter (3) zur Aufnahme des Nichteisenmetalls (2), wobei der Behälter (3) im Wesentlichen die Form eines Quaders mit sechs Seitenflächen (5, 6, 7, 8) aufweist,
b. mindestens ein steuerbares Heiz-Element (9) zur aktiven Zufuhr von Wärme in das Nichteisenmetall (2), und
c. mindestens zwei steuerbare Kühl-Elemente (10) zur aktiven Abfuhr von Wärme aus dem Nichteisenmetall (2),
d. **dadurch gekennzeichnet, dass** jeweils zwei Kühl-Elemente (10) an einander gegenüberliegenden Seitenflächen (5, 6, 7, 8) angeordnet sind.

2. Vorrichtung nach Anspruch 1, **dadurch gekennzeichnet, dass** die Kühl-Elemente (10) im Wesentlichen flächig und parallel zu mindestens einer Seitenfläche (5, 6, 7, 8) angeordnet sind.

3. Vorrichtung nach einem der Ansprüche 1 oder 2, **dadurch gekennzeichnet, dass** die Kühl-Elemente (10) zumindest an der mindestens einen Seitenfläche (8) angeordnet sind, zu der hin der Behälter (3) offen ist.

4. Vorrichtung nach einem der Ansprüche 1 bis 3, **dadurch gekennzeichnet, dass** die Kühl-Elemente (10) zwischen dem Behälter (3) und dem mindestens einen Heiz-Element (9) angeordnet sind.

5. Vorrichtung nach einem der Ansprüche 1 bis 4, **dadurch gekennzeichnet, dass** die Kühl-Elemente (10) mindestens ein Kühl-Rohr (11) zum Durchströmen eines Kühl-Gases (12) aufweisen.

6. Vorrichtung gemäß Anspruch 1, **dadurch gekennzeichnet, dass** das mindestens eine Heiz-Element (9) und/oder die Kühl-Elemente (10) entlang mindestens einer Seitenfläche (5, 6, 7, 8) bewegbar sind.

7. Verfahren zum Schmelzen und/oder Kristallisieren von Nichteisenmetallen (2), insbesondere von Silizium, umfassend die Schritte:
a. Bereitstellen einer Vorrichtung gemäß einem der vorhergehenden Ansprüche mit einem Behälter (3) zur Aufnahme des festen und/oder flüssigen Nichteisenmetalls (2),
b. Aufschmelzen des Nichteisenmetalls (2) in dem Behälter (3) oder Einfüllen des bereits aufgeschmolzenen und flüssigen Nichteisenmetalls (2) in den Behälter (3),
c. Aktives Abführen von Wärme aus dem flüssigen Nichteisenmetall (2) mit den steuerbaren Kühl-Elementen (10), und
d. Gesteuertes Kristallisieren des flüssigen Nichteisenmetalls (2) in dem Behälter (3) durch die Steuerung der Wärmeabfuhr.

8. Verfahren nach Anspruch 7, **dadurch gekennzeichnet, dass** die Kühl-Elemente (10) zumindest teilweise von einem Kühl-Fluid (12) durchströmt werden.

9. Verfahren nach Anspruch 8, **dadurch gekennzeichnet, dass** das aktive Abführen von Wärme durch den Druck des Kühl-Fluid (12) und/oder die Durchflussmenge des Kühl-Fluid (12) gesteuert wird.

## Claims

1. Device for the melting and/or crystallising of non-ferrous metals (2), especially of silicon, comprising
a. a container (3) for receiving the non-ferrous metal (2), wherein the container (3) has substantially the shape of a cuboid having six lateral surfaces (5, 6, 7, 8),
b. at least one controllable heating element (9) for the active supply of heat into the non-ferrous metal (2), and
c. at least two controllable cooling elements (10) for the active removal of heat from the non-ferrous metal (2),
d. **characterized in that** two respective cooling elements (10) are arranged on opposing lateral surfaces (5, 6, 7, 8).

2. Device according to claim 1, **characterised in that** the at least one cooling element (10) is arranged substantially plane and parallel to at least one lateral surface (5, 6, 7, 8).

3. Device according to one of claims 1 or 2, **characterised in that** the at least one cooling element (10) is arranged at least on the at least one lateral side (8) toward which the container (3) is open.

4. Device according to any one of claims 1 to 3, **characterised in that** the at least one cooling element (10) is arranged between the container (3) and the at least one heating element (9).

5. Device according to any one of claims 1 to 4, **characterised in that** the at least one cooling element (10) has at least one cooling tube (11) for the passage of a cooling gas (12).

6. Device according to claim 1, **characterised in that** the at least one heating element (9) and/or the at least one cooling element (10) is movable along at least one lateral surface (5, 6, 7, 8).

7. Process for the melting and/or crystallising of non-ferrous metals (2), especially of silicon, including the following steps:
a. providing a device according to one of the preceding claims comprising a container (3) for receiving the solid and/or liquid non-ferrous metal (2),
b. melting of the non-ferrous metal (2) in the container (3) or introduction of the already molten and liquid non-ferrous metal (2) into the container (3),
c. active removal of heat from the liquid non-ferrous metal (2) using the controllable cooling elements (10), and
d. controlled crystallising of the liquid non-ferrous metal (2) in the container (3) by controlling the removal of heat.

8. Process according to claim 7, **characterised in that** a cooling fluid (12) passes at least in part through the cooling elements (10).

9. Process according to claim 8, **characterised in that** the active removal of heat is controlled by the pressure of the cooling fluid (12) and/or the flow rate of the cooling fluid (12).

## Revendications

1. Dispositif de fusion et/ou cristallisation de métaux non ferreux (2), en particulier de silicium, comprenant :
a. un récipient (3) pour la réception du métal non ferreux (2), où le récipient (3) présente essentiellement la forme d'un parallélépipède rectangle avec six faces latérales (5, 6, 7, 8),
b. au moins un élément chauffant réglable (9) pour l'apport actif de chaleur dans le métal non ferreux (2), et
c. au moins deux éléments refroidissants réglables (10) pour l'élimination active de chaleur depuis le métal non ferreux (2),
d. **caractérisé en ce que** chacun des deux éléments refroidissants (10) est disposé sur une face latérale (5, 6, 7, 8) opposée.

2. Dispositif selon la revendication 1, **caractérisé en ce que** les éléments refroidissants (10) sont essentiellement plans et disposés de manière parallèle à au moins une face latérale (5, 6, 7, 8).

3. Dispositif selon l'une des revendications 1 et 2, **caractérisé en ce que** les éléments refroidissants (10) sont disposés au moins sur la au moins une face latérale (8), par laquelle le récipient (3) est ouvert.

4. Dispositif selon l'une des revendications 1 à 3, **caractérisé en ce que** les éléments refroidissants (10) sont disposés entre le récipient (3) et le au moins un élément chauffant (9).

5. Dispositif selon l'une des revendications 1 à 4, **caractérisé en ce que** les éléments refroidissants (10) présentent au moins un tube de refroidissement (11) pour le passage d'un gaz réfrigérant (12).

6. Dispositif selon la revendication 1, **caractérisé en ce que** le au moins un élément chauffant (9) et/ou les éléments refroidissants (10) sont mobiles le long d'au moins une face latérale (5, 6, 7, 8).

7. Procédé de fusion et/ou de cristallisation de métaux non ferreux (2), en particulier de silicium, comprenant les étapes de :
a. Préparation d'un dispositif selon l'une des revendications précédentes, avec un récipient (3) pour la réception du métal non ferreux (2) solide et/ou liquide,
b. Fusion du métal non ferreux (2) dans le récipient (3) ou introduction du métal non ferreux (2) déjà fondu et liquide, dans le récipient (3),
c. Élimination active de la chaleur depuis le métal non ferreux (2) avec les éléments refroidissants (10) réglables, et
d. Cristallisation contrôlée du métal non ferreux (2) liquide dans le récipient (3), par réglage de l'élimination de la chaleur.

8. Procédé selon la revendication 7, **caractérisé en ce que** les éléments refroidissants (10) sont traversés au moins partiellement par un fluide réfrigérant (12).

9. Procédé selon la revendication 8, **caractérisé en ce que** l'élimination active de la chaleur est réglée par la pression du fluide réfrigérant (12) et/ou le débit du fluide réfrigérant (12).
